# EUROPÄISCHE PATENTSCHRIFT

(11) **EP 1 224 690 B1**
(45) Veröffentlichungstag und Bekanntmachung des Hinweises auf die Patenterteilung: **20.07.2005**
(21) Anmeldenummer: 00983052.2
(22) Anmeldetag: 24.10.2000
(51) Int. Cl.: H01L 21/00

(54) **ANLAGE ZUR BEARBEITUNG VON WAFERN**
MACHINE FOR PROCESSING WAFERS
INSTALLATION PERMETTANT L'USINAGE DE PLAQUETTES DE SILICIUM

(30) Priorität: 29.10.1999 DE 19952195
(43) Veröffentlichungstag der Anmeldung: 24.07.2002
(73) Patentinhaber: Infineon Technologies AG, 81669 München (DE)
(72) Erfinder: ELGER, Jürgen, 90602 Pyrbaum (DE)
(74) Vertreter: Epping Hermann & Fischer
(86) Internationale Anmeldenummer: PCT/DE2000/003743
(87) Internationale Veröffentlichungsnummer: WO 2001/033611

(56) Entgegenhaltungen:
- DE-A- 19 745 386
- US-A- 4 672 185
- US-A- 5 432 702
- PATENT ABSTRACTS OF JAPAN vol. 1995, no. 01, 28. Februar 1995 (1995-02-28) -& JP 06 286824 A (SHARP CORP), 11. Oktober 1994 (1994-10-11)
- PATENT ABSTRACTS OF JAPAN vol. 1999, no. 14, 22. Dezember 1999 (1999-12-22) -& JP 11 260883 A (DAINIPPON SCREEN MFG CO LTD), 24. September 1999 (1999-09-24)

## Beschreibung

Die Erfindung betrifft eine Anlage zur Bearbeitung von Wafern mit mehreren Fertigungseinheiten und Messeinheiten sowie einem Transport system zum Transport der wafer.

Derartige Anlagen umfassen eine Vielzahl von Fertigungseinheiten, mit welchen unterschiedliche Fertigungsprozesse durchgeführt werden. Bei diesen Fertigungsprozessen handelt es sich insbesondere um Ätzprozesse, Nasschemieverfahren, Diffusionsprozesse sowie diverse Reinigungsverfahren wie zum Beispiel CMP-Verfahren (Chemical Mechanical Polishing). Für jeden dieser Prozesse sind eine oder mehrere Fertigungseinheiten vorgesehen, in welchen verschiedene Fertigungsschritte eines Fertigungsprozesses durchgeführt werden.

Zudem umfassen derartige Anlagen eine Vielzahl von Messeinheiten. In den Messeinheiten wird die Bearbeitungsqualität von einem oder mehreren Fertigungsschritten eines Fertigungsprozesses überprüft.

Der gesamte Fertigungsprozess unterliegt strengen Reinheitsanforderungen, so dass die Fertigungseinheiten und Messeinheiten in einem Reinraum oder in einem System von Reinräumen angeordnet sind.

Die Wafer werden in als Kassetten ausgebildeten Behältern in vorbestimmten Losgrößen über ein Transportsystem den einzelnen Fertigungseinheiten zugeführt. Auch der Abtransport der Kassetten nach Bearbeitung dieser Wafer erfolgt über das Transportsystem.

Das Transportsystem weist typischerweise ein Fördersystem mit einer Vielzahl von Förderern auf, welche beispielsweise in Form von Rollenförderern ausgebildet sind. Die Kassetten mit den Wafern werden dabei auf den Rollenförderern aufliegend transportiert. Alternativ kann das Fördersystem auch aus Stetigförderern, Hängeförderern oder dergleichen bestehen.

Zur Steuerung derartiger Anlagen ist üblicherweise ein Materialdispositionssystem vorgesehen. Mittels dieses Materialdispositionssystems werden Wafer in bestimmter Anzahl aus einem Lager oder dergleichen ausgelagert und in Losen zusammengefasst. Für die einzelnen Lose werden Arbeitspläne erstellt, die die einzelnen Bearbeitungsschritte enthalten, welche mit den Wafern beim Durchlauf durch die Anlage in den einzelnen Fertigungseinheiten und Messeinheiten durchgeführt werden. Zudem erfolgt über das Materialdispositionssystem eine Vergabe von Prioritäten für die einzelnen Wafer. Anhand dieser Priorisierung ergibt sich eine bestimmte Bearbeitungsreihenfolge für die Wafer der unterschiedlichen Lose.

Schließlich werden die Wafer über das Materialdispositionssystem dem Transportsystem zugeführt, über welches die Zufuhr der Behälter mit den Wafern zu den einzelnen Fertigungseinheiten und Messeinheiten erfolgt. Dabei werden die Behälter im Transportsystem mit vorgegebenen losbezogenen Transportaufträgen eingelastet. Die Transportaufträge enthalten insbesondere die Zielorte für die einzelnen Behälter, wobei die Zielorte von Fertigungseinheiten und Messeinheiten gebildet sind.

Anhand dieser Transportaufträge werden die Behälter den einzelnen Zielorten zugeführt. Nachteilig hierbei ist, dass dabei das Transportsystem häufig ungleichmäßig ausgelastet ist. Insbesondere tritt häufig der Fall auf, dass eine beträchtliche Anzahl von Förderern überlastet ist, so dass für die darauf befindlichen Behälter unerwünschte Wartezeiten auftreten. Derartige Wartezeiten vergrößern die Durchlaufzeiten der Wafer durch die Anlage beträchtlich, was insbesondere auch zu einer unerwünschten Erhöhung der Herstellkosten der Wafer führt.

Der Erfindung liegt die Aufgabe zugrunde, eine Anlage der eingangs genannten Art so auszubilden, dass die Durchlaufzeiten der Wafer bei deren Bearbeitung in der Anlage möglichst gering sind.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Erfindungsgemäß ist dem Transportsystem eine Transportsteuereinheit zugeordnet, welche Mittel zur Erfassung des Auslastungszustands der Anlage und Mittel zur Speicherung der Bearbeitungsreihenfolgen der Wafer aufweist.

In Abhängigkeit des Auslastungszustands der Anlage und der Bearbeitungsreihenfolge der Wafer werden in der Transportsteuereinheit Steuerbefehle generiert und sind an das Transportsystem zur Steuerung des Ablaufs des Transports der Wafer ausgebbar.

Der Grundgedanke der Erfindung liegt darin, dass über die Transportsteuereinheit der Transport der Wafer über das Transportsystem schnell und flexibel an den Auslastungszustand der Anlage angepasst werden kann. Insbesondere sind Mittel zur Erfassung der Auslastungszustände der einzelnen Komponenten des Transportsystems vorgesehen, die beispielsweise von Sensoren gebildet sind.

Anhand dessen wird in der Transportsteuereinheit erfasst, welche Transportwege aktuell überlastet und welche noch freie Transportkapazitäten aufweisen. Zudem wird vorzugsweise auch erfasst, wie stark die momentane Auslastung der einzelnen Fertigungseinheiten und Messeinheiten ist.

Anhand dieser Informationen werden in der Transportsteuereinheit Steuerbefehle generiert, anhand derer die Wafer unter optimaler Ausnutzung der Transport- und Bearbeitungskapazitäten der Anlage den einzelnen Zielorten zugeführt werden.

Insbesondere können die Steuerbefehle derart ausgebildet werden, dass an die aktuellen Transport- und Bearbeitungskapazitäten angepasste Transportaufträge generiert werden.

Dabei werden vorteilhaft auch Transportaufträge für einzelne Behälter mit Wafern in Teiltransportaufträge gegliedert. Die Bindung der Wafer an einen bestimmten Behälter während des Durchlaufs durch die Anlage wird damit aufgegeben. Vielmehr werden über die Transportsteuereinheit die Wafer so gruppiert, dass diese angepasst an den aktuellen Bearbeitungszustand möglichst direkt und ohne Wartezeiten der jeweils geeigneten Fertigungseinheit oder Messeinheit zugeführt werden.

Zudem erfolgt in der Transportsteuereinheit für diese Wafer jeweils eine geeignete Auswahl des Transportwegs, wobei insbesondere überlastete Teilstrecken des Transportsystems umfahren werden.

Auf diese Weise können die Durchlaufzeiten der Wafer durch die Anlage sehr gering gehalten werden.

Die Erfindung wird im nachstehenden Ausführungsbeispiel anhand der Zeichnungen erläutert. Es zeigen:
- Figur 1:: Schematische Darstellung einer Anlage zur Fertigung von Halbleiterprodukten mit einer Anordnung von Bearbeitungsstationen.
- Figur 2:: Blockschaltbild von Komponenten zur Ablaufsteuerung der Anlage gemäß Figur 1.

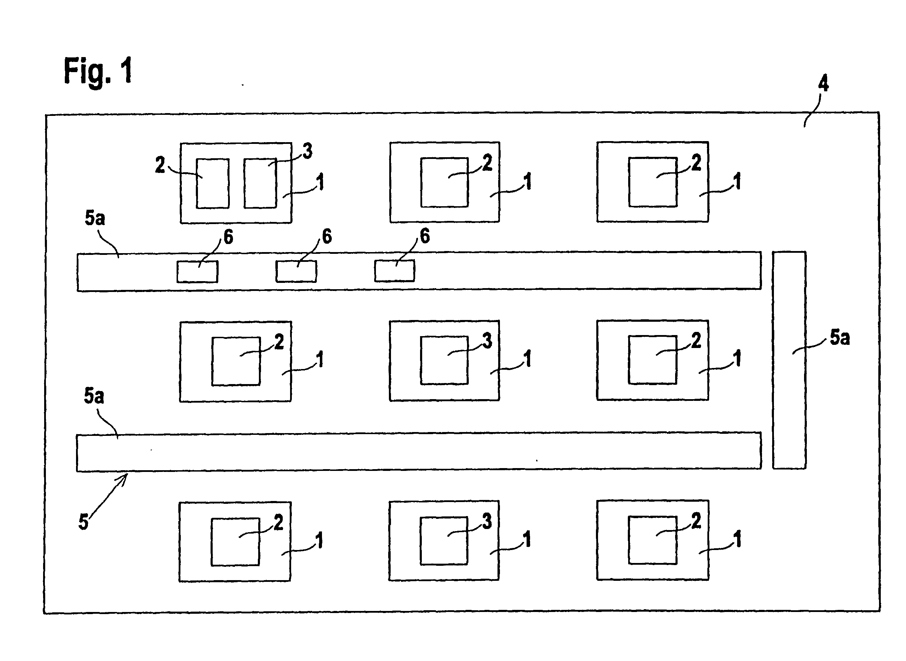

In Figur 1 ist schematisch eine Anlage zur Bearbeitung von Wafern dargestellt. Die Anlage weist eine Vielzahl von Bearbeitungsstationen 1 auf, wobei in einer Bearbeitungsstation 1 eine oder mehrere Fertigungseinheiten 2 oder Messeinheiten 3 vorgesehen sind.

Die Fertigungseinheiten 2 dienen zur Durchführung unterschiedlicher Fertigungsschritte bei den für die Bearbeitung der Wafer erforderlichen Fertigungsprozessen. Diese Fertigungsprozesse umfassen insbesondere Atzprozesse, Nasschemieverfahren, Diffusionsprozesse sowie Reinigungsverfahren. Für die einzelnen Fertigungsprozesse können entsprechend der Anzahl der durchzuführenden Fertigungsschritte eine oder mehrere Fertigungseinheiten 2 vorgesehen sein.

Die Messeinheiten 3 dienen zur Überprüfung der Bearbeitungsqualität der in den einzelnen Fertigungseinheiten 2 durchgeführten Fertigungsschritte.

Die Bearbeitungsstationen 1 mit den einzelnen Fertigungseinheiten 2 und Messeinheiten 3 sind in einem Reinraum 4 angeordnet und über ein Transportsystem miteinander verbunden. Alternativ können die Bearbeitungsstationen 1 über ein System von Reinräumen 4 verteilt sein.

Das Transportsystem weist ein Fördersystem 5 mit mehreren Förderern 5a auf, welches die Wafer den einzelnen Bearbeitungsstationen 1 zuführt. Für die Zufuhr und Abfuhr der Wafer weisen die Bearbeitungsstationen 1 nicht dargestellte Be- und Entladestationen auf. Die Wafer werden dabei in Behältern 6 transportiert, welche vorzugsweise als Kassetten ausgebildet sind. Die Förderer 5a können in Form von Rollenförderern, Stetigförderern oder dergleichen ausgebildet sein. Zwischen den Förderern 5a können Übergabestationen oder dergleichen zur Übergabe der Wafer vorgesehen sein. Das Transportsystem kann zudem ein nicht dargestelltes Speichersystem aufweisen, welches mehrere im Reinraum 4 verteilte Speicher umfasst. Diese Speicher können insbesondere als Stocker ausgebildet sein. In diesen Speichern werden Behälter 6 mit Wafern zwischengelagert. Beispielsweise können dort Behälter 6 zwischengelagert werden, welche Wafer enthalten, die in den einzelnen Fertigungseinheiten 2 fehlerhaft bearbeitet wurden. Zu geeigneten Zeitpunkten werden diese zur Nacharbeit aus den Speichern ausgelagert und bestimmten Fertigungseinheiten 2 zugeführt.

Im vorliegenden Ausführungsbeispiel erfolgt der Transport der Wafer über das Transportsystem vollautomatisch und ohne jeglichen Personaleinsatz. Alternativ kann der Transport der Wafer auch teilweise manuell erfolgen.

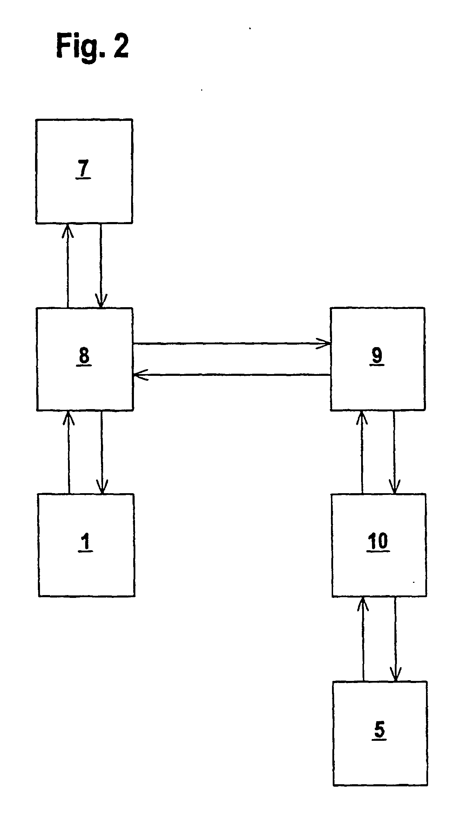

Figur 2 zeigt ein Blockschaltbild zur Ablaufsteuerung der Anlage zur Bearbeitung von Wafern. Ein zentrales Produktionsplanungs- und Steuerungssystem 7 ist an ein Produktionsleitsystem 8 angeschlossen. An das Produktionsleitsystem 8 sind die einzelnen Bearbeitungsstationen 1 mit den Fertigungseinheiten 2 und Messeinheiten 3 angeschlossen. An das Produktionsleitsystem 8 ist zudem eine Transportsteuereinheit 9 angeschlossen. An die Transportsteuereinheit 9 wiederum ist eine Fördertechniksteuerung 10 angeschlossen, welche mit dem Fördersystem 5 des Transportsystems verbunden ist.

Die vorgenannten Komponenten der Anlage weisen jeweils wenigstens eine Rechnereinheit auf. Die Anschlüsse zwischen den einzelnen Komponenten sind jeweils als bidirektionale Datenleitungen zwischen den einzelnen Rechnereinheiten dieser Komponenten ausgebildet.

Das Produktionsplanungs- und Steuerungssystem 7 dient zur Kapazitätsermittlung und Bedarfsermittlung für die gesamte Anlage. Die Kapazitäten und Bedarfe zur Bearbeitung der Wafer in den einzelnen Fertigungs- 2 und Messeinheiten 3 werden für Zeiträume in der Größenordnung von einigen Tagen bis Wochen vorausgeplant. Anhand dieser Planung erfolgt eine Zuordnung von bestimmten Bearbeitungsschritten für Fertigungseinheiten 2 und Messeinheiten 3, die hierfür besonders geeignet sind. Zudem werden in dem Produktionsplanungs- und Steuerungssystem 7 Fertigungsaufträge und Arbeitspläne für die Bearbeitung der Wafer generiert.

In dem Produktionsleitsystem 8 werden zu Beginn des Bearbeitungsprozesses mehrere Wafer zu Losen zusammengefasst, wobei die Wafer eines Loses anfänglich untergebracht werden. Hierzu werden die entsprechenden Wafer über das Produktionsleitsystem 8 aus einem Lager ausgelagert und manuell oder maschinell in Behältern 6 untergebracht.

Von dem Produktionsplanungs- und Steuerungssystem 7 werden in das Produktionsleitsystem 8 die einzelnen Arbeitspläne und Fertigungsaufträge eingelesen, abgespeichert und verwaltet.

Anhand der Arbeitspläne und Fertigungsaufträge werden vom Produktionsleitsystem 8 die entsprechenden Vorgaben in die einzelnen Fertigungs- 2 und Messeinheiten 3 eingelesen. Von den einzelnen Fertigungs- 2 und Messeinheiten 3 werden jeweils die aktuellen Zustände dieser Einheiten an das Produktionsleitsystem 8 gemeldet. Insbesondere werden auch die aktuellen Bearbeitungszustände der einzelnen Wafer in den einzelnen Fertigungs- 2 und Messeinheiten 3 in das Produktionsleitsystem 8 eingelesen.

Sämtliche dieser Informationen werden im Produktionsleitsystem 8 fortlaufend registriert, wodurch die aktuellen Bearbeitungszustände der Wafer sowie die Auslastungszustände der Fertigungs- 2 und Messeinheiten 3 in dem Produktionsleitsystem 8 verfügbar sind.

Anhand dieser Daten wird im Produktionsleitsystem 8 der Ausstoß der Anlage an Wafern erfasst und an das Produktionsplanungs- und Steuerungssystem 7 rückgemeldet.

Zudem erfolgt anhand der Daten im Produktionsleitsystem 8 eine Priorisierung für die Bearbeitung der einzelnen Wafer oder Lose, wobei diese Planung typischerweise innerhalb eines Zeithorizonts von einigen Minuten bis Stunden variiert. Die Priorisierung der Wafer ist dabei insbesondere abhängig von deren Bearbeitungszuständen.

Die Transportsteuereinheit 9 dient zur Steuerung des gesamten Transportsystems. Hierzu werden in der Transportsteuereinheit 9 die Auslastungszustände der einzelnen Fertigungseinheiten 2, Messeinheiten 3 und insbesondere der Komponenten des Transportsystems fortlaufend erfasst. In Abhängigkeit dieser Parameter sowie der Bearbeitungszustände der Wafer werden in der Transportsteuereinheit 9 Steuerbefehle generiert, in Abhängigkeit derer der Ablauf des Transports der Wafer erfolgt. Diese Steuerung erfolgt vorzugsweise nahezu ohne Verzögerungszeiten oder mit Reaktionszeiten von maximal einigen Sekunden.

Die Bearbeitungszustände und Bearbeitungsreihenfolgen der Wafer werden von dem Produktionsleitsystem 8 in die Transportsteuereinheit 9 eingegeben. Die Bearbeitungsreihenfolgen der Wafer sind durch die Vergabe der Prioritäten in dem Produktionsleitsystem 8 vorgegeben. In Abhängigkeit hiervon werden Transportaufträge für die Wafer in dem Produktionsleitsystem 8 generiert und in die Transportsteuereinheit 9 eingelesen. Diese Transportaufträge beziehen sich vorzugsweise jeweils auf ein Los mit Wafern. Die Auslastungszustände der einzelnen Fertigungs- 2 und Messeinheiten 3 werden in dem Produktionsleitsystem 8 erfasst und ebenfalls in die Transportsteuereinheit 9 eingelesen.

Zur Erfassung der Auslastungszustände der weiteren Komponenten der Anlage, insbesondere des Transportsystems ist ein System von Sensoren vorgesehen, deren Ausgangssignale in die Transportsteuereinheit 9 eingelesen werden.

Dabei sind die Sensoren insbesondere von Barcodelesegeräten gebildet. Mit diesen Barcodelesegeräten werden Barcodes erfasst, die zum einen auf den einzelnen Behältern 6 und zum anderen direkt auf den Wafern angeordnet sind. Anhand dieser Barcodes sind die Behälter 6 und Wafer eindeutig identifizierbar.

Eine Identifikation der Wafer selbst ist insbesondere deshalb notwendig, da während der Bearbeitung der Wafer in den Fertigungs- 2 und Messeinheiten 3 Wafer unterschiedlicher Lose in einen Behälter 6 gefüllt werden können. Dann reicht die Identifizierung eines Behälters 6 alleine nicht mehr aus, um die Wafer entsprechend ihrer Bearbeitungszustände beim Durchlauf durch die Anlage verfolgen zu können.

Die Barcodelesegeräte sind in ausreichender Anzahl an den einzelnen Förderern 5a des Transportsystems angeordnet. Zudem sind Barcodelesegeräte auch an den Übergabestationen zwischen den Förderern 5a angeordnet. Schließlich können zusätzlich zu den Barcodelesegeräten auch weitere Sensoren wie zum Beispiel Lichtschranken oder dergleichen vorgesehen sein, mit welchen jeweils der Durchgang von Behältern 6 durch eine Überwachungsstrecke erfasst wird.

Die an die Transportsteuereinheit 9 angeschlossene Fördertechniksteuerung 10 weist im wesentlichen eine oder mehrere Rechnereinheiten zur Steuerung der Antriebselemente des Transportsystems auf. Die Antriebselemente sind insbesondere von Motoren und Gebern gebildet, mittels derer die Komponenten des Transportsystems, insbesondere die einzelnen Förderer 5a angetrieben werden. Der Betrieb der Fördertechniksteuerung 10 ist über die Steuerbefehle gesteuert, welche von der Transportsteuereinheit 9 in die Fördertechniksteuerung 10 eingelesen werden. Umgekehrt werden Steuerparameter der Fördertechniksteuerung 10, insbesondere die Betriebszustände der einzelnen Komponenten des Transportsystems und eventuelle Störmeldungen, von der Fördertechniksteuerung 10 in die Transportsteuereinheit 9 eingelesen.

In der Transportsteuereinheit 9 werden die Ausgangssignale der Fördertechniksteuerung insbesondere dazu verwendet, um die Auslastung der einzelnen Komponenten des Transportsystems zu erfassen. Hierzu wird die Anzahl der auf den Komponenten des Transportsystems, insbesondere der auf den Förderern 5a befindlichen Behälter 6 mit Wafern erfasst.

Daraus ergibt sich die Belegungsdichte der Förderer 5a mit Behältern 6. Insbesondere wird ermittelt, ob einzelne Förderer 5a überlastet sind, wodurch Behälterstaus entstehen können. Zudem wird die Verfügbarkeit der einzelnen Komponenten des Transportsystems erfasst, insbesondere, ob die einzelnen Förderer 5a funktionsfähig sind oder nicht.

Aus den mittels des Sensorsystems gewonnenen Informationen und den aus dem Produktionsleitsystem 8 eingelesenen Daten werden in der Transportsteuereinheit 9 die Steuerbefehle für die Fördertechniksteuerung 10 generiert. Zunächst wird in der Transportsteuereinheit 9 ausgewertet, ob sich in einem Behälter 6 Wafer nur eines Loses oder mehrerer Lose befinden. In letzterem Fall wird ein für einen Behälter 6 in dem Produktionsleitsystem 8 generierter Transportauftrag in der Transportsteuereinheit 9 nicht unverändert übernommen sondern in geeignete Teiltransportaufträge unterteilt. Die unterschiedlichen Teiltransportaufträgen zugeordneten Wafer werden dann entsprechend in separaten Behältern 6 den jeweils geeigneten Fertigungs- 2 oder Messeinheiten 3 zugeführt. Hierzu werden die Wafer an geeigneten Stellen, insbesondere an den Übergabestationen oder speziellen Umladevorrichtungen in die geeigneten Behälter 6 umgeladen.

Die Transportaufträge oder die Teiltransportaufträge bilden Teile der Steuerbefehle, die von der Transportsteuereinheit 9 an die Fördertechniksteuerung 10 ausgegeben werden.

Des weiteren werden anhand der im Transportsteuereinheit 9 abgespeicherten Informationen geeignete Zielorte für die zu transportierenden Behälter 6 sowie geeignete Transportwege für die Behälter 6 ermittelt, welche ebenfalls Bestandteile der von der Transportsteuereinheit 9 ausgegebenen Steuerbefehle sind.

Die Auswahl der Zielorte erfolgt in Abhängigkeit der Bearbeitungszustände der Wafer. Je nach Bearbeitungszustand der Wafer in einem Behälter 6 wird eine geeignete Fertigungs- 2 oder Messeinheit 3 als Zielort definiert, falls diese momentan freie Bearbeitungskapazitäten aufweist. Ist die betreffende Fertigungs- 2 oder Messeinheit 3 momentan jedoch überlastet oder gar außer Betrieb, so wird ein Zielort definiert, der möglichst nahe an dieser Messeinheit 3 oder Fertigungseinheit 2 liegt, um zu gewährleisten, dass der Behälter 6 dieser Fertigungs- 2 oder Messeinheit 3 schnell zugeführt werden kann, sobald diese wieder verfügbar ist. Zweckmäßigerweise werden die Behälter 6 in einem Speicher zwischengelagert, der möglichst nahe an der jeweiligen Fertigungs- 2 und Messeinheit 3 liegt.

Der jeweilige Transportweg wird in der Transportsteuereinheit 9 so bestimmt, dass das Anfahren des Zielorts nur über solche Komponenten des Transportsystems erfolgt, die freie Transportkapazitäten aufweisen. Insbesondere erfolgt die Wahl des Transportwegs derart, dass überlastete oder außer Betrieb befindliche Förderer 5a umgangen werden.

## Patentansprüche

1. Anlage zur Bearbeitung von Wafern mit mehreren Fertigungseinheiten (2) und Messeinheiten (3) sowie einem Transportsystem (5) zum Transport der Wafer, bei der das Transportsystem mehrere Komponenten (5a) enthält, auf denen die Wafer transportiert werden, wobei dem Transportsystem eine Transportsteuereinheit (9) zugeordnet ist, welche Mittel zur Erfassung des Auslastungszustands der Anlage einschließlich der einzelnen Komponenten des Transportsystems und Mittel zur Speicherung der Bearbeitungsreihenfolge der Wafer aufweist, und wobei in Abhängigkeit des Auslastungszustands der Anlage einschließlich der einzelnen Komponenten des Transportsystems und der Bearbeitungsreihenfolge der Wafer in der Transportsteuereinheit (9) Steuerbefehle generiert werden und an das Transportsystem zur Steuerung des Ablaufs des Transports der Wafer ausgebbar sind.

2. Anlage nach Anspruch 1, **dadurch gekennzeichnet, dass** das Transportsystem ein Fördersystem (5) mit mehreren Förderern (5a) aufweist, auf welchen die Wafer transportiert werden, insbesondere in Behältern (6) transportiert werden.

3. Anlage nach einem der Ansprüche 1 - 2, **dadurch gekennzeichnet, dass** die Mittel zur Erfassung des Auslastungszustands des Transportsystems von Sensoren gebildet sind.

4. Anlage nach Anspruch 3, **dadurch gekennzeichnet, dass** die Sensoren von Barcodelesegeräten gebildet sind, anhand derer die Identifikation von mit Barcodes gekennzeichneten Behältern (6) und/oder von mit Barcodes gekennzeichneter einzelner Wafer erfolgt.

5. Anlage nach Anspruch 3, **dadurch gekennzeichnet, dass** die Sensoren von Lichtschranken oder dergleichen gebildet sind.

6. Anlage nach einem der Ansprüche 3 - 5, **dadurch gekennzeichnet, dass** die Sensoren am Transportsystem angeordnet sind.

7. Anlage nach einem der vorigen Ansprüche, **dadurch gekennzeichnet, dass** die Transportsteuereinheit (9) an ein Produktionsleitsystem (8) angeschlossen ist, in welchem fortlaufend der Bearbeitungszustand der Wafer einzelner Lose registriert wird.

8. Anlage nach Anspruch 7, **dadurch gekennzeichnet, dass** sie weiter Mittel zum Einlesen der Auslastungszustände einzelner Fertigungseinheiten (2) und Messeinheiten (3) von dem Produktionsleitsystem (8) in die Transportsteuereinheit (9) und Abspeichern in der Transportsteuereinheit (9) aufweist.

9. Anlage nach Anspruch 8, **dadurch gekennzeichnet, dass** in dem Produktionsleitsystem (8) Mittel zum Registrieren der Bearbeitungszustände der Wafer unterschiedlicher Lose und zum fortlaufenden Festlegen der Bearbeitungsreihenfolgen der Wafer in Abhängigkeit hiervon vorgesehen sind.

10. Anlage nach Anspruch 9, **dadurch gekennzeichnet, dass** sie Mittel zum Einlesen der Bearbeitungszustände und Bearbeitungsreihenfolgen der Wafer von dem Produktionsleitsystem (8) in die Transportsteuereinheit (9) aufweist.

11. Anlage nach Anspruch 10, **dadurch gekennzeichnet, dass** sie Mittel zum Einlesen der Bearbeitungsreihenfolgen der Wafer in Form von Transportaufträgen für einzelne Behälter (6) oder Lose in die Transportsteuereinheit (9) aufweist.

12. Anlage nach einem der Ansprüche 10 oder 11, **dadurch gekennzeichnet, dass** das Produktionsleitsystem (8) Mittel zum Zuteilen von Prioritäten an die Lose von Wafern aufweist.

13. Anlage nach einem der vorigen Ansprüche, **dadurch gekennzeichnet, dass** das Transportsystem eine Fördertechniksteuerung (10) aufweist, welche an die Transportsteuereinheit (9) angeschlossen ist.

14. Anlage nach Anspruch 13, **dadurch gekennzeichnet, dass** mit der Fördertechniksteuerung (10) Motoren und Geber zum Antrieb von Komponenten des Transportsystems gesteuert werden.

15. Anlage nach Anspruch 14, **dadurch gekennzeichnet, dass** die Fördertechniksteuerung (10) Mittel zum Einlesen von Störungsmeldungen einzelner Komponenten des Transportsystems in die Transportsteuereinheit (9) aufweist.

16. Anlage nach einem der Ansprüche 14 oder 15, **dadurch gekennzeichnet, dass** die Fördertechniksteuerung (10) Mittel zum Einlesen von in der Transportsteuereinheit (9) generierten Steuerbefehle aufweist.

17. Anlage nach Anspruch 3 oder einem der Ansprüche 4 bis 16, soweit sie auf Anspruch 3 rückbezogen sind, **dadurch gekennzeichnet, dass** mittels der Sensoren die Anzahl der auf den einzelnen Komponenten des Transportsystems befindlichen Wafer registriert wird und in der Transportsteuereinheit (9) abgespeichert wird.

18. Anlage nach Anspruch 17, **dadurch gekennzeichnet, dass** mit den Sensoren die Belegungsdichte mit Behältern (6) für die einzelnen Komponenten des Transportsystems ermittelt und in der Transportsteuereinheit (9) abgespeichert wird.

19. Anlage nach einem der Ansprüche 11 - 18, **dadurch gekennzeichnet, dass** die Transportsteuereinheit (9) Mittel zum Zerlegen der Transportaufträge in Teiltransportaufträge aufweist.

20. Anlage nach Anspruch 19, **dadurch gekennzeichnet, dass** das Mittel zum Zerlegen die Zerlegung in Teiltransportaufträge in Abhängigkeit der Bearbeitungszustände der entsprechenden Wafer durchführt.

21. Anlage nach einem der Ansprüche 19 oder 20, **dadurch gekennzeichnet, dass** die Transportsteuereinheit (9) Mittel zum Definieren von Transportwege für die einzelnen Transportaufträge oder Teiltransportaufträge und zum Ausgeben der Transportwege als Bestandteil der Steuerbefehle aufweist.

22. Anlage nach Anspruch 21, **dadurch gekennzeichnet, dass** das Mittel zum Definieren und Ausgeben die Transportwege in der Transportsteuereinheit (9) in Abhängigkeit der Bearbeitungszustände der Wafer und/oder in Abhängigkeit der Auslastungszustände der Komponenten des Transportsystems, der Fertigungseinheiten (2) und/oder der Messeinheiten (3) wählt.

23. Anlage nach Anspruch 22, **dadurch gekennzeichnet, dass** durch das Mittel zum Definieren und Ausgeben ein Transportweg für einen Behälter (6) zu einer einen Zielort bildenden Fertigungs- (2) oder Messeinheit (3) ausgewählt wird, falls diese verfügbare Arbeitskapazität aufweist.

24. Anlage nach Anspruch 23, **dadurch gekennzeichnet, dass** durch das Mittel zum Definieren und Ausgeben ein Transportweg für einen Behälter (6) zu einem Puffer in der Umgebung eines Zielorts ausgewählt wird, falls die den Zielort bildende Fertigungseinheit (2) oder Messeinheit (3) keine verfügbare Arbeitskapazität aufweist.

25. Anlage nach einem der vorigen Ansprüche, **dadurch gekennzeichnet, dass** die Transportsteuereinheit (9) wenigstens eine Rechnereinheit aufweist.

## Claims

1. Installation for processing wafers with a plurality of fabrication units (2) and a plurality of measurement units (3) as well as a transport system (5) for transporting the wafers, in which installation the transport system contains a plurality of components (5a), on which the wafers are transported, a transport control unit (9), which has means for detecting the capacity utilization of the installation including the individual components of the transport system and means for saving the processing sequence of the wafers, being allocated to the transport system, and, as a function of the capacity utilization of the installation including the individual components of the transport system and the processing sequence of the wafers, control instructions being generated in the transport control unit (9) and being able to be output to the transport system for controlling the wafer transport procedure.

2. The installation as claimed in Claim 1, **characterized in that** the transport system has a conveyor system (5) with a plurality of conveyors (5a), on which the wafers are transported, in particular are transported in containers (6).

3. The installation as claimed in one of Claims 1 - 2, **characterized in that** the means for detecting the capacity utilization of the transport system are formed by sensors.

4. The installation as claimed in Claim 3, **characterized in that** the sensors are formed by barcode readers, with the aid of which the identification of containers (6) labelled with barcodes and/or individual wafers labelled with barcodes is carried out.

5. The installation as claimed in Claim 3, **characterized in that** the sensors are formed by photoelectric barriers or the like.

6. The installation as claimed in one of Claims 3 - 5, **characterized in that** the sensors are arranged at the transport system.

7. The installation as claimed in one of the preceding claims, **characterized in that** the transport control unit (9) is connected to a production management system (8), in which the processing status of the wafers of individual batches is registered continuously.

8. The installation as claimed in Claim 7, **characterized in that** it furthermore has means for entering the capacity utilizations of individual fabrication units (2) and measurement units (3) by the production management system (8) into the transport control unit (9), and saving in the transport control unit (9).

9. The installation as claimed in Claim 8, **characterized in that** means are provided for registering the processing statuses of the wafers of different batches, and for continuously establishing the processing sequences of the wafers as a function thereof.

10. The installation as claimed in Claim 9, **characterized in that** it has means for entering the processing statuses and processing sequences of the wafers by the production management system (8) into the transport control system (9).

11. The installation as claimed in Claim 10, **characterized in that** it has means for entering the processing sequences of the wafers in the form of transport requests for individual containers (6) or batches into the transport control unit (9).

12. The installation as claimed in one of Claims 10 and 11, **characterized in that** the production management system (8) has means for assigning priorities to the batches of wafers.

13. The installation as claimed in one of the preceding claims, **characterized in that** the transport system has a conveyor control (10), which is connected to the transport control unit (9).

14. The installation as claimed in Claim 13, **characterized in that** motors and transducers for driving components of the transport system are controlled using the conveyor control (10).

15. The installation as claimed in Claim 14, **characterized in that** the conveyor control (10) has means for entering error messages of individual components of the transport system into the transport control unit (9).

16. The installation as claimed in one of Claims 14 and 15, **characterized in that** the conveyor control (10) has means for entering control instructions generated in the transport control unit (9).

17. The installation as claimed in Claim 3 or one of Claims 4 to 16, when they refer to Claim 3, **characterized in that** the number of wafers located on the individual components of the transport system is registered by means of the sensors, and is saved in the transport control unit (9).

18. The installation as claimed in Claim 17, **characterized in that** the occupancy by containers (6) for the individual components of the transport system is determined using the sensors, and is saved in the transport control unit (9).

19. The installation as claimed in one of Claims 11 - 18, **characterized in that** the transport control unit (9) has means for breaking down the transport requests into transport subrequests.

20. The installation as claimed in claim 19, **characterized in that** the breakdown means perform the breakdown into transport subrequests as a function of the processing statuses of the corresponding wafers.

21. The installation as claimed in one of Claims 19 and 20, **characterized in that** the transport control unit (9) has means for defining transport paths for the individual transport requests or transport subrequests, and for outputting the transport paths as a constituent of the control instructions.

22. The installation as claimed in Claim 21, **characterized in that** the defining and outputting means selects the transport paths in the transport control unit (9) as a function of the processing statuses of the wafers and/or as a function of the capacity utilizations of the components of the transport system, the fabrication units (2) and/or the measurement units (3).

23. The installation as claimed in Claim 22, **characterized in that** the defining and outputting means selects a transport path for a container (6) to a fabrication (2) or measurement unit (3) forming a destination, if the latter has available working capacity.

24. The installation as claimed in Claim 23, **characterized in that** the defining and outputting means selects a transport path for a container (6) to a buffer in the vicinity of a destination, if the fabrication unit (2) or measurement unit (3) forming the destination does not have any available working capacity.

25. The installation as claimed in one of the preceding claims, **characterized in that** the transport control unit (9) has at least one computer unit.

## Revendications

1. Installation d'usinage de tranches comprenant plusieurs unités (2) de fabrication et plusieurs unités (3) de mesure, ainsi qu'un système (5) de transport des tranches, dans laquelle le système de transport comporte plusieurs éléments (5a) sur lesquels les tranches sont transportées, dans lequel il est associé au système de transport une unité (9) de commande de transport qui a des moyens de détection de l'état d'utilisation de l'installation, y compris des divers éléments du système de transport, et des moyens de mémorisation de la succession d'usinages des tranches, et dans lequel il est engendré, en fonction de l'état d'utilisation de l'installation, y compris des divers éléments du système de transport et de la succession d'usinages des tranches, dans l'unité (9) de commande de transport, des ordres de commande qui sont envoyés au système de transport pour commander le déroulement du transport des tranches.

2. Installation suivant la revendication 1, **caractérisée en ce que** le système de transport a un système (5) de convoyage ayant plusieurs convoyeurs (5a) sur lesquels les tranches sont transportées, notamment dans des récipients (6).

3. Installation suivant l'une des revendications 1 ou 2, **caractérisée en ce que** les moyens de détection de l'état d'utilisation du système de transport sont formés par des capteurs.

4. Installation suivant la revendication 3, **caractérisée en ce que** les capteurs sont formés par des appareils de lecture de codes barres au moyen desquels s'effectue l'identification de récipients (6) **caractérisés par** des codes barres et/ou des tranches individuelles **caractérisées par** des codes barres.

5. Installation suivant la revendication 3, **caractérisée en ce que** les capteurs sont formés par des cellules photoélectriques ou analogues.

6. Installation suivant l'une des revendications 3 à 5, **caractérisée en ce que** les capteurs sont disposés sur le système de transport.

7. Installation suivant l'une des revendications précédentes, **caractérisée en ce que** l'unité (9) de commande de transport est raccordée à un système (8) de pilotage de production, dans lequel on enregistre en continu l'état d'usinage des tranches des lots individuels.

8. Installation suivant la revendication 7, **caractérisée en ce qu'**elle comprend en outre des moyens de lecture des états d'utilisation des diverses unités (2) de fabrication et des unités (3) de mesure par le système (8) de pilotage de la production dans l'unité (9) de commande de transport et de mémorisation dans l'unité (9) de commande de transport.

9. Installation suivant la revendication 8, **caractérisée en ce qu'**il est prévu, dans le système (8) de pilotage de la production, des moyens d'enregistrement des états d'usinage des tranches de lots différents et de détermination en continu des successions d'usinages des tranches en fonction de ceux-ci.

10. Installation suivant la revendication 9, **caractérisée en ce qu'**elle comprend des moyens de lecture des états d'usinage et des successions d'usinage des tranches par le système (8) de pilotage de la production dans l'unité (9) de commande de transport.

11. Installation suivant la revendication 10, **caractérisée en ce qu'**elle comprend des moyens de lecture des successions d'usinages des tranches sous la forme d'ordres de transport pour les divers récipients (6) ou lots dans l'unité (9) de commande de transport.

12. Installation suivant l'une des revendications 10 ou 11, **caractérisée en ce que** le système (8) de pilotage de la production comprend des moyens d'affectation de priorité aux lots de tranches.

13. Installation suivant l'une des revendications précédentes, **caractérisée en ce que** le système de transport a une commande (10) de technique de convoyage qui est raccordée à l'unité (9) de commande de transport.

14. Installation suivant la revendication 13, **caractérisée en ce que** des moteurs et des manipulateurs pour l'entraînement d'éléments du système de transport sont commandés par la commande (10) de technique de convoyage.

15. Installation suivant la revendication 14, **caractérisée en ce que** la commande (10) de technique de convoyage a des moyens de lecture d'annonces de perturbation des divers éléments du système de transport dans l'unité (9) de commande de transport.

16. Installation suivant l'une des revendications 14 ou 15, **caractérisée en ce que** la commande (10) de technique de convoyage a des moyens de lecture d'ordres de commande engendrés dans l'unité (9) de commande de transport.

17. Installation suivant la revendication 3 ou l'une des revendications 4 à 16, pour autant qu'elle se rapporte à la revendication 3, **caractérisée en ce qu'**au moyen des capteurs, le nombre des tranches se trouvant sur les divers éléments du système de transport est enregistré et est mémorisé dans l'unité (9) de commande de transport.

18. Installation suivant la revendication 17, **caractérisée en ce que**, par les capteurs, la densité d'occupation par des récipients (6) pour les divers éléments du système de transport est déterminée et est mémorisée dans l'unité (9) de commande de transport.

19. Installation suivant l'une des revendications 11 à 18, **caractérisée en ce que** l'unité (9) de commande de transport a des moyens de décomposition des ordres de transport en des sous-ordres de transport.

20. Installation suivant la revendication 19, **caractérisée en ce que** les moyens de décomposition effectuent la décomposition en sous-ordres de transport en fonction des états d'usinage des tranches correspondantes.

21. Installation suivant l'une des revendications 19 ou 20, **caractérisée en ce que** l'unité (9) de commande de transport a des moyens de définition de trajet de transport pour les ordres de transport individuels ou les sous-ordres de transport individuels et pour émettre les voies de transport en tant que parties des ordres de commande.

22. Installation suivant la revendication 21, **caractérisée en ce que** les moyens de définition et d'émission choisissent les voies de transport dans l'unité (9) de commande de transport en fonction des états d'usinage des tranches et/ou en fonction des états d'utilisation des éléments du système de transport des unités (2) de fabrication et/ou des unités (3) de mesure.

23. Installation suivant la revendication 22, **caractérisée en ce que**, par les moyens de définition et d'émission, un trajet de transport pour un récipient (6) vers une unité (2) de fabrication ou une unité (3) de mesure constituant un lieu de destination est choisi dans le cas où cette unité a une capacité de travail disponible.

24. Installation suivant la revendication 23, **caractérisée en ce que**, par les moyens de définition et d'émission, une voie de transport pour un récipient (6) vers un tampon au voisinage d'un lieu de destination est choisie dans le cas où l'unité (2) de fabrication ou l'unité (3) de mesure constituant le lieu de destination n'a pas de capacité de travail disponible.

25. Installation suivant l'une des revendications précédentes, **caractérisée en ce que** l'unité (9) de commande de transport a au moins une unité informatique.
